# EUROPEAN PATENT APPLICATION

(11) **EP 1 065 508 A2**
(43) Date of publication of application: **03.01.2001**
(21) Application number: 00112665.5
(22) Date of filing: 15.06.2000
(51) Int. Cl.: G01R 21/133

(54) **Tamper/power failure discrimination method and apparatus**

(30) Priority: 30.06.1999 US 345696
(71) Applicant: Siemens Power Transmission & Distribution, Inc., Wendel, NC 27591 (US)
(72) Inventor: Burns, Gordon R., West Lafayette, IN 47906 (US); Slater, Byron J., Lafayette, IN 47905 (US)
(74) Representative: Allen, Derek

(57) **Abstract**

An electrical utility meter includes a source of energy consumption measurement signals, a removable housing, a measurement circuit, and a tamper protection circuit. The removable housing has an installed position and an uninstalled position. The removable housing further has a power input for receiving electrical power from a power line when in the installed position. The measurement circuit is secured to the housing and is coupled to the source of energy consumption measurement signals to receive energy consumption measurement signals therefrom when the housing is in the installed position. The measurement circuit is configured to generate metering information based at least in part on said measurement signals. The tamper detection circuit is secured to the housing and is operable to detect an interruption of the electrical power to the housing input and determine whether the housing is in the uninstalled position when an interruption of the electrical power to the housing input is detected.

## Description

### Field of the Invention

The present invention relates to utility revenue meters, and in particular, utility revenue meters that include electronic measurement circuits.

### Background of the Invention

Electrical utility meters are devices that are used for, among other things, tracking the consumption of electrical energy. Many meters, including those used in connection with residential housing customers, consist of an enclosed unit that connects between the utility power line and the customer electrical system. The meter measures and records energy consumption on an ongoing basis. From time to time, the utility provider obtains the consumption information from each meter and bills the customer accordingly.

Electrical utility meters have historically employed rotating disks that operate using electromagnetic induction. The rotating disk rotated proportionally to the amount of power consumed. A series of mechanical counters in the meter accumulated or registered the number of rotations of the disk. The utility then billed the customer based on the number of rotations that had occurred since the last billing cycle.

More recently, electronic meters have been introduced that accumulate energy consumption information without using a rotating disk. Such electronic meters use digital processing techniques to obtain power consumption information. Electronic meters not only eliminate moving parts and the drawbacks typically associated therewith, but also facilitate sophisticated energy consumption information processing which may be used to increase the efficiency of the energy delivery network. Electronic meters typically consist of a source of energy consumption measurement signals and a measurement circuit. The energy consumption measurement signals are typically analog signals that are representative of the energy consumption by the system being metered. The measurement circuit digitizes the energy measurement signals and then performs calculations on the digitized signals to obtain consumption information in the form of watt-hours, volt amp-hours, and/or other energy-related values. The measurement circuit accumulates the energy consumption information for use in billing and other purposes.

A common problem associated with metering is energy theft through meter tampering. Meter tampering causes losses of hundreds of millions of dollars of revenue each year in North America alone. The primary goal of meter tampering is to consume electrical power that is not measured or accumulated by the meter. An obvious way to avoid metering of consumed power is to remove the meter from the power lines such that no record is generated for the power consumed while the meter is removed. The meter may then be reconnected before the utility personnel returns to read the meter.

To detect such removal, utility meters often contain a sealing arrangement that must be broken to effectuate removal of the meter. The sealing arrangement may include a special wax seal in combination with a wire loop. Most sealing arrangements, including the wax and wire seal described above, are destroyed when the meter is removed. Thus, if the meter is removed and then replaced before the utility personnel returns to read the meter, the utility personnel can detect a tamper event by observing the broken seal. The use of a such a sealing arrangement, or *single use* sealing arrangement, has the drawback of requiring replacement every time the meter is removed from the power lines, regardless of whether such removal is related to tampering. Accordingly, meter servicing personnel must necessarily carry materials and tools for re-sealing meters in the event that a meter may have been tampered with or that a meter requires servicing.

The above drawback to the use of single use meter sealing arrangements is amplified in modular meter designs. In particular, modular meters have been developed in which the high power sensing elements are in a separate housing from the processing/measurement circuitry. Because the processing/measurement circuitry of such modular meters operates to register and display the accumulated energy consumption information, modular meters are susceptible to energy theft by simply removing the module containing the processing/measurement circuitry. In theory, however, the prior art single use sealing arrangement may be employed at the interconnection of the processing/measurement module and the sensing module to detect such tampering.

However, the single use meter sealing arrangement is particularly disadvantageous in the modular meter because in some respects, the module containing the processing/ measurement circuitry is *designed* to be removed. Specifically, one of the purposes of implementing a modular meter is to allow for upgrade of the meter to include different functionality *without* having to replace the entire meter. Instead, only the processing/measurement module need be replaced. The modular meter thus addresses the recent need for such enhanced upgrade capability that has been spurred in part by the deregulation of the electrical power service industry. As a result, it is likely that the frequency with which the processing/measurement module of a modular meter will be removed is significantly higher than the frequency with which single-piece meters have historically been removed from the power lines.

Accordingly, it is likely that single use anti-tamper sealing arrangements on processing/measurement modules of modular meters will need to be replaced at a greater frequency than those used on ordinary single piece meters. Thus, the inconvenience created by the single use sealing arrangement is amplified in modular meter designs.

Accordingly, there is a need for a reusable tamper protection arrangement that is not destroyed when meter is removed while still recording or logging information noting the tamper event. Moreover, a need exists for a reusable tamper protection arrangement that is easy to re-use and does not require any special tools. Finally, a need exists for such an arrangement that has high reliability.

### Summary of the Invention

The present invention fulfills the above need as well as others, by employing a tamper protection circuit in an electronic meter that is secured to a removable meter housing and is operable to detect whether the housing is properly installed when power is removed from the housing. In particular, potential tamper scenarios are detected when power to the housing is interrupted. The circuit distinguishes tampering from normal power outages by detecting whether the housing is in proper position when the power interruption is detected. If tampering is detected, a flag may optionally be set. The flag may then be communicated to utility personnel to inform the utility of the tamper event.

In one embodiment, the present invention is an electrical utility meter for measuring a quantity of electrical power consumed by a load. The meter includes a source of energy consumption measurement signals, a removable housing, a measurement circuit, and a tamper protection circuit. The removable housing has an installed position and an uninstalled position. The removable housing further has a power input for receiving electrical power from a power line when in the installed position. The measurement circuit is secured to the housing and is coupled to the source of energy consumption measurement signals to receive energy consumption measurement signals therefrom when the housing is in the installed position. The measurement circuit is configured to generate metering information based at least in part on said measurement signals. The tamper detection circuit is secured to the housing and is operable to detect an interruption of the electrical power to the housing input and determine whether the housing is in the uninstalled position when an interruption of the electrical power to the housing input is detected.

It is noted that after communication of the tamper flag to the utility, the tamper flag may be reset in the tamper protection circuit. Accordingly, the tamper protection circuit of the present invention does not involve the destruction and replacement of parts.

The above discussed features and advantages of the present invention, as well as others, will become more readily apparent by reference to the following description and accompanying drawings.

### Brief Description of the Drawings

Fig. 1 shows a block diagram of an exemplary electronic utility meter having a tamper protection arrangement according to the present invention, wherein the housing of the electronic utility meter is in an uninstalled position;
Fig. 2 shows a block diagram of the meter of Fig. 1 in the installed position;
Fig. 3 shows an exploded view of an exemplary modular utility meter having a tamper protection arrangement according to the present invention;
Fig. 4 shows an exploded view of an installation configuration of the modular utility meter of Fig. 3;
Fig. 5 shows an cutaway section of the meter of Fig. 3 wherein the measurement module is in the installed position with respect to the sensor module;
Fig. 6 shows a schematic diagram of the sensor module of the meter of Fig. 3;
Fig. 7 shows a schematic diagram of the measurement module of the meter of Fig. 3; and
Fig. 8 shows an exemplary flow diagram of the operations of the processor of the measurement module of Fig. 7.

### Detailed Description

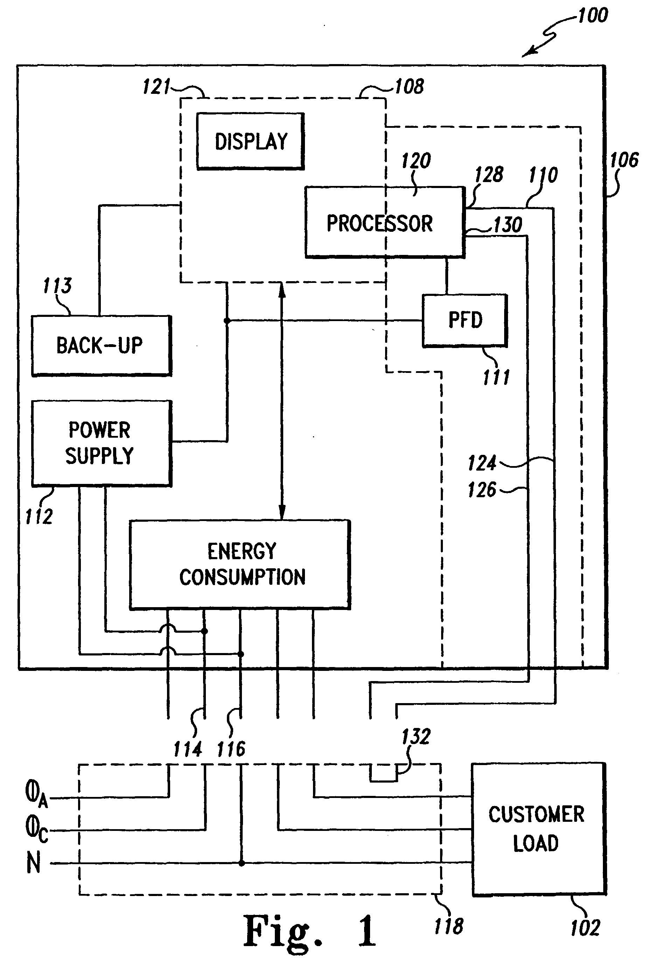

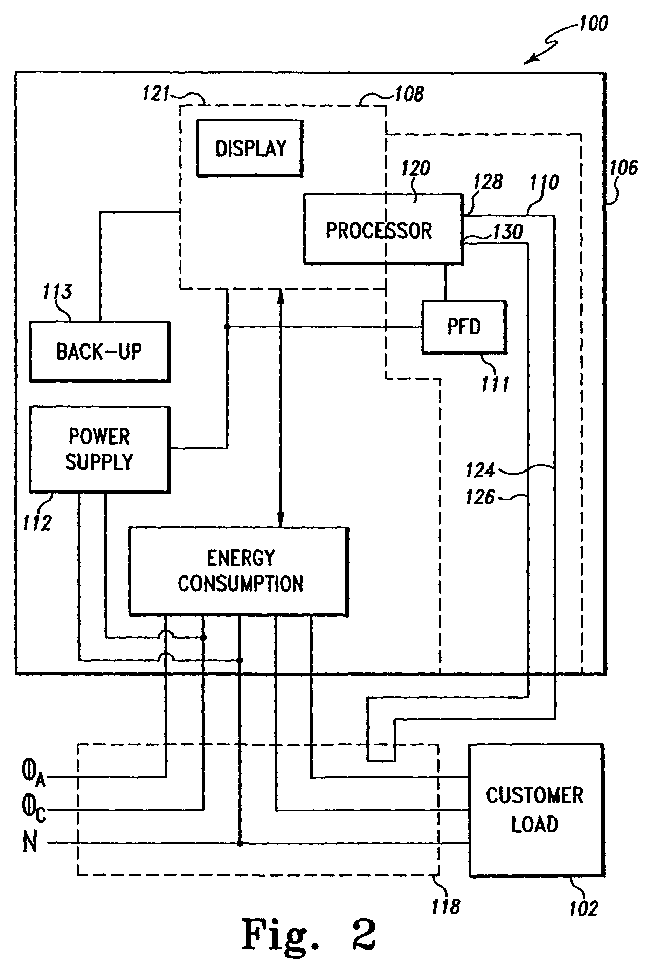

Figs. 1 and 2 show a block diagram of an exemplary electronic utility meter 100 according to the present invention. The meter 100 is a device that measures the quantity of electrical energy consumed by a customer load 102. The customer load 102, may, for example, be the electrical system of an industrial facility, a commercial establishment, or a residential building. The customer load 102 is configured to obtain power from a phase A power line ØA, a phase C power line ØC, and a neutral power line N in a well known "network" wiring configuration. It will be noted, however, that the meter 100 according to the present invention may readily be adapted to accommodate electrical systems that receive electrical power through any standard wiring configuration, including, but not limited to, three wire delta, four wire wye, four wire delta and single phase wiring configurations.

The meter 100 includes a source of energy consumption measurement signals 104, a removable housing 106, a measurement circuit 108, a tamper protection circuit 110, and a power supply 112. The meter 100 further includes a power failure detection circuit 111 and a back-up power supply 113.

The source of energy consumption measurement signals 104 may suitably be any circuit or combination of circuits that generates signals representative of power flowing through the power lines ØA, ØC, and N. For example, the source of energy consumption measurement signals 104 may suitably include one or more voltage sensor and one or more current sensors. The voltage sensors connect between each phase power line and the neutral power line and generate a signal representative of the voltage on each power line. The current sensors may suitably include a coil that completes the circuit from the phase A power line ØA and the phase C power line ØC to the customer load 102, and a device for measuring current on the coils. In some systems, the meter does not complete the circuit from the power lines to the load, but rather obtains current information from an external transformer coupled to the power lines ØA, ØC. Various forms of voltage sensors (such as divider circuits) and current sensors (such as embedded coils, current transformers, and shunts) are well known.

The removable housing 106 is a structural enclosure or container that has an installed position and an uninstalled position. However, it is noted that the use of the words "enclosure" or "container" herein in no way imply that the housing 106 must *completely* enclose anything. In any event, Fig. 1 shows the removable housing 106 in the uninstalled position and Fig. 2 shows the removable housing 106 in the installed position. The removable housing 106 is configured to be received by a mounting device 118. The mounting device 118 is a device that provides an interconnection between a meter, such as the meter 100, and the power lines ØA, ØC and N. Such devices have various designs which are well-known. The removable housing 106 is in the installed position when the removable housing 106 is coupled to the mounting device 118 (see Fig. 2). Contrariwise, the removable housing 106 is in the uninstalled position when the removable housing 106 is not coupled to the mounting device 118 (see Fig. 1).

The removable housing 106 has two power inputs 114, 116 in the form of connectors that receive electrical power from the phase C power line ØC when the housing 106 is in the installed position (see Fig. 2). In the embodiment described herein, the two power inputs 114, 116 are in turn coupled to the power supply 112. The power supply 112 is a circuit that converts alternating current ("AC") electrical power received from the phase C power line ØC via the power inputs 114 and 116 to DC bias power for use by the measurement circuit 108 and other circuitry.

The back-up power supply 113 is a circuit or device that is operably coupled to provide power in the event of an interruption in power to the power inputs 114, 116. The back-up power supply 113 is operable to provide power for limited operation of the meter 100 in the event of a power interruption to allow, for example, critical data to be stored in non-volatile memory, or communication of the power failure event to a remote facility. Such back-up power supplies are well known and may consist of one or more batteries and/or an energy storage capacitor.

The measurement circuit 108 is a circuit that is secured (either directly or indirectly) to the removable housing 106 and is furthermore coupled to the source of energy consumption measurement signals 104 to receive energy consumption measurement signals therefrom. To this end, the measurement circuit 108 in the embodiment disclosed herein includes a processor 120, which as will be discussed below, also constitutes a portion of the tamper protection circuit 110. In any event, the measurement circuit 108 is a circuit that may include additional processors, analog-to-digital converters, multiplexers and other digital devices that converts the energy measurement signals generated by the source of energy consumption measurement signals 104 into metering information.

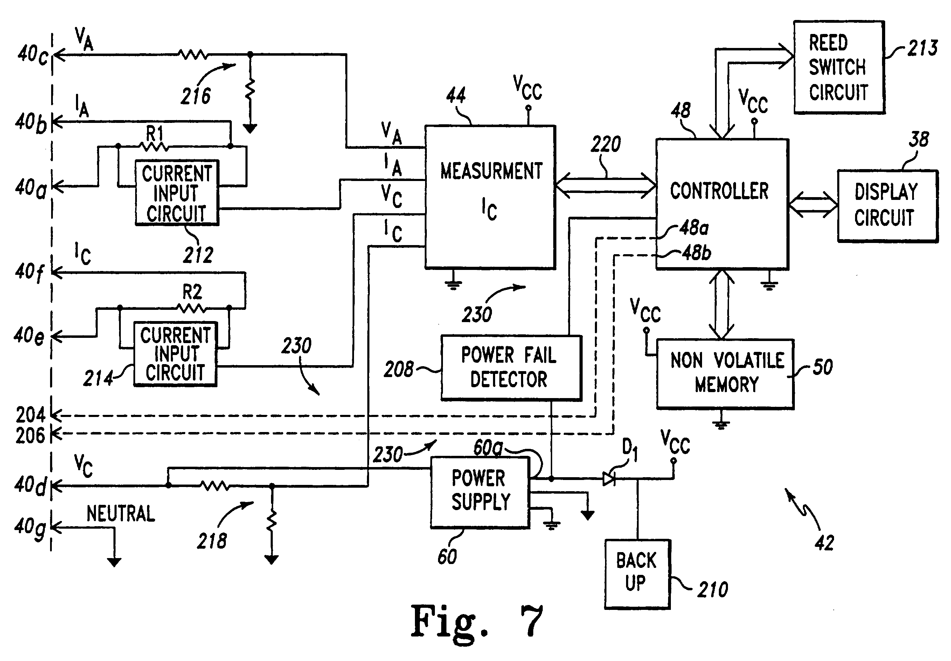

Metering information is information related to energy usage by the customer, typically in standardized units, and may include accumulated kilowatt-hour (kwh), volt amp-hour (va-hr), or reactive volt amp-hour (var-hr) information. Metering information is typically in a format that is readily communicated to utility providers through transmission or via a visible display. Examples of suitable measurement circuits that are operable to generate metering information from energy consumption measurement signals are discussed below in connection with Fig. 7.

Referring back to Fig. 1 and 2, the tamper protection circuit 110 is also secured to the removable housing 106 and is operable to detect an interruption of the electrical power to the power inputs 114, 116 and determine whether the housing 106 is in the uninstalled position when such an interruption of the electrical power is detected. To detect the interruption of electrical power to the power inputs 114, 116, the tamper protection circuit 110 of the exemplary embodiment described herein is operable to detect when the voltage at the output 122 of the power supply 112 falls below a predetermined threshold.

To this end, in the exemplary embodiment described herein, the tamper protection circuit 110 includes a power failure detection circuit 111 that is coupled to an output 122 of the power supply 112. The power failure detection circuit 111shown in Fig. 1 is a device that generates a power fail signal when the voltage detected at the output 122 of the power supply 112 falls below a predetermined threshold. To this end, the power failure detection circuit 111 may include a comparator having one differential input connected to a zener diode reference voltage circuit and the other differential input connected to the power supply output 122. Such circuits are well-known.

The tamper protection circuit 110 also preferably includes a processor that receives the power fail signal and then, responsive thereto, determines whether the housing 106 is in the installed or uninstalled position. Specifically, in the embodiment of Figs. 1 and 2, the processor 120 of the measurement circuit 108 also acts as the processor of the tamper protection circuit 110. It will be appreciated that the functions of the processor in the tamper protection circuit 110 may readily be incorporated to the functions performed by any processor of a suitable measurement circuit of an electronic utility meter by those of ordinary skill in the art. Specifically, because the tamper protection circuit consumes relatively little computational operations, the processing functions of the tamper protection circuit 110 will not significantly affect the operation of any processor in most modern utility meter measurement circuits. Alternatively, the tamper protection 110 may suitably employ a separate processor, or a processor that is used for other meter functions that do not involve the measurement circuit 108.

In any event, the processor 120 of the present embodiment determines whether the removable housing 106 is in the installed or uninstalled position using an installation continuity circuit. The installation continuity circuit includes a first housing terminal 124 and a second housing terminal 126. The first housing terminal 124 is coupled to a source of bias voltage, shown herein as a first output 128 of the processor 120. Alternatively the first housing terminal 124 may be coupled to alternative source of bias voltage, such as, for example, the output 122 of the power supply 112. The second housing terminal 126 is operably coupled to a first input 130 of the processor 120.

The first housing terminal 124 is configured to be electrically coupled to the second housing terminal 126 when the removable housing 106 is in the installed position (see Fig. 2). Contrariwise, the first housing terminal 124 is configured to be electrically decoupled from the second housing terminal when the housing is in the uninstalled position (see Fig. 1). To this end, at least a portion of the first housing terminal 124 and the second housing terminal 126 are adapted to be electrically coupled to a conductor 132, located within the mounting device 118, when the removable housing 106 is in the installed position.

It is noted that the processor 120 is suitably programmed to determine that the removable housing 106 is in the uninstalled position based on whether the bias voltage is present on the second housing terminal 126.

In an alternative embodiment, the power failure detection circuit 111 is not coupled to the output 122 of the power supply 112, but rather is coupled to the power inputs 114 and 116 themselves. An example of such a power failure detection circuit may suitably include a threshold comparator, coupled to the power inputs 114, 116, that generates a pulse-width modulated signal having a duty cycle that is representative of the voltage on the power lines. The processor 120 would then determine whether power is interrupted to the power inputs 114, 116 by determining whether the duty cycle of the pulse-width modulated signal was below a predetermined threshold.

Moreover, in other alternative embodiments, the installation continuity circuit need not rely on a conductor 132 in the mounting device 118. Instead, a mechanical switch may be employed that is forced into a first position when the housing 106 is in the installed position and reverts to a second position when the housing 106 is in the uninstalled position. The switch would be configured to close the circuit between the first housing terminal 124 and the second housing terminal 126 when in the first position and to open the circuit between such terminals when in the second position. While the use of such a switch eliminates the need for a mounting device having the conductor 132, it nevertheless undesirable introduces a moving part into the tamper protection arrangement of the present invention. In yet other embodiments, the installation continuity circuit may include optical components instead of or in addition to electrical components.

In the operation of the embodiment of the present invention described above, a technician installs the removable housing 106 to facilitate metering of the customer load 102. To this end, the removable housing 106 is coupled to the mounting device 118 (see Fig. 2). When the removable housing 106 is installed, the source of energy consumption signals 104 is operably coupled to the power lines ØA, ØC, N. Likewise, the first housing terminal 124 and the second housing terminal 126 are electrically coupled through the conductor 132.

Once installed, the meter 100 carries out energy consumption metering functions as is well known in the art. In particular, the source of energy consumption measurement signals 104 detects the voltages and currents on the power lines and generates energy consumption measurement signals therefrom. Such signals, may, for example, consist of analog signals representative of the voltage waveform on each phase and signals representative of the current waveform on each phase. However, other meters may employ signals that provide pulse-width modulated signals representative of the energy consumption represented by the voltage and current on the power lines. Circuits capable of generating such energy consumption measurement signals are well known.

Meanwhile, the power supply 112 receives AC electrical power from the power inputs 114 and 116 and provides bias voltage at its output 122. The bias voltage provides bias power to the processor 120 as well as other elements of the measurement circuit 108 and the tamper protection circuit 110 as needed.

Returning to the energy consumption measurement operation, the source of energy consumption measurement signals 104 provides the energy consumption measurement signals to the measurement circuit 108. The measurement circuit 108 converts the energy consumption measurement signals to digital measurement signals. In alternative embodiments, however, the energy consumption measurement signals themselves may already be digital signals. In either event, the processor 120, either alone or in conjunction with other processors or circuits within the measurement circuit 108, generates metering information from the digital measurement signals. The metering information includes, among other things, information related to energy consumption over time, referred to herein as accumulated energy consumption information. The accumulated energy consumption information is used for, among other things, billing the customer for energy usage.

The metering information is then stored and/or communicated externally. The metering information may be stored in a memory that is internal to the processor 120 or in a memory, not shown, that resides in another portion of the measurement circuit 108. The metering information may be communicated externally through a visual display 121, or through an external communication circuit, not shown. Suitable display and communication circuitry for use in conveying metering information are well known in the art.

The tamper protection circuit 110 in the disclosed embodiment essentially does not affect operation of the meter 100 during normal metering operations. Nevertheless, the processor 120 preferably generates a bias voltage in the form of a high logic voltage at its first output 128 at all times that the processor 120 has bias power.

In any event, the tamper protection circuit 110 primarily operates upon detection of an interruption of power to the power inputs 114 and 116. The electrical power at the power inputs 114 and 116 is typically only interrupted when the power lines ØA, ØC and N experience a power outage, or when the removable housing 106 is removed from the mounting device 118.

As discussed below in further detail, the tamper protection circuit 110 of the present invention distinguishes between a power outage on the power lines ØA, ØC and N, which is not a tamper event, and removal of the removable housing 106 from the mounting device 118, which potentially constitutes a tamper event. Specifically, if the removable housing 106 is removed from the mounting device 118 as shown in Fig. 1, then measurement circuit 104 cannot generate metering information in the form of accumulated energy consumption information. If the removable housing 106 is removed and another means is used to complete the circuit between the power lines ØA, ØC, and N and the customer load 102, then the customer load 102 can consume power without detection, and therefore without being billed by the utility for the power usage. To detect such energy theft, the tamper protection circuit 110 determines whether the housing 106 is in the installed position upon detection of a power interruption to the power inputs 114, 116.

Such operation is illustrated through a discussion of the operation of the tamper protection circuit 110 during a power outage as well as during removal of the removable housing 106 from the mounting device 118.

During a power outage, little or no voltage or current is present on the electrical power on the power lines ØA, ØC. As a result, little or no voltage is provided to the power inputs 114, 116 from the phase C power line ØC. Because little or no voltage is provided to the power inputs 114, 116, the power supply 112 cannot produce the bias voltage at its output 122. While the power supply 112 may provide the bias voltage for a short period of time due to the dissipation of charge on one or more internal capacitors, the loss of input power eventually results in a substantial reduction in, if not a total loss of, voltage at the output 122 of the power supply 112.

When the bias voltage at the output 122 falls below the predetermined threshold, the power failure detection circuit 111 generates the power fail signal and provides it to the processor 120. Meanwhile, the back-up power supply 113, responsive to the reduction in bias voltage at the output 122, begins to provide auxiliary bias power to the tamper detection circuit 110 and at least part of the measurement circuit 108. In particular, the back-up power supply 113 provides auxiliary bias power to at least the processor 120.

The processor 120 receives the power fail signal and then operates to determine whether a positive logic voltage is present on the first input 130. Because the power interruption is due to the power line outage, and thus the housing 106 is stilled coupled to the mounting device 118, the first housing terminal 124 and the second housing terminal 126 are still electrically connected through the conductor 132. As a result, the first input 130 is still connected to the first output 128 through the first housing terminal 124, the second housing terminal 126, and the conductor 132. Accordingly, the processor 120 determines that the high logic voltage, which is generated at the first output 128, is present at the first input 130, thereby signifying that the removable housing 106 is in the *installed* position.

By contrast, if the housing 106 is removed from the mounting device 118, then the processor 120 determines that a tamper event has occurred.

Specifically, when the removable housing 106 is removed from the mounting device 118, the power input 114 is decoupled from the phase C power line ØC and the power input 116 is decoupled from the neutral line N. Because the power inputs 114 and 116 are decoupled from the power lines ØC and N, respectively, no voltage or current is to the power supply 112. As a result, the power supply 112 cannot produce the bias voltage at its output 122.

In response to the drop in voltage at the output 122, the power failure detection circuit 111 operates as described above to generate the power fail signal and provide the power fail signal to the processor 120. Meanwhile, the back-up power supply 113, as also discussed above, begins to provide auxiliary bias power to at least the processor 120. The processor 120 receives the power fail signal and then operates to determine whether a high logic voltage is present on the first input 130.

Because the power interruption is due to the removal of the removable housing 106, the first housing terminal 124 and the second housing terminal 126 are no longer electrically connected through the conductor 132. As a result, the first input 130 is no longer connected to the first output 128. Accordingly, the processor 120 determines that the high logic voltage, which is generated at the first output 128, is not present at the first input 130, thereby signifying that the removable housing 106 is in the *uninstalled* position.

The processor 120, upon determining that the housing 106 is in the uninstalled position during a power interruption to the power inputs 114 and 116, registers a potential tamper event, preferably by setting a flag that is stored in non-volatile memory, not shown. The non-volatile memory may suitably be non-volatile RAM, an electrically erasable programmable read only memory ("EEPROM"), an electromagnetic relay, or other similar device. The flag may be used by the processor 120 to light a special tamper indicator on the display 121 when power is restored to the meter. The flag may only be reset by a utility technician by way of a magnetic reed switch, key switch, or by entering a special code through a keypad on the meter or on an external programming or communication facility, not shown.

Alternatively, the tamper event could be communicated via a communication circuit to a remote monitoring unit. Such communication could be effectuated once the meter is replaced in the housing 106.

The tamper detection circuit 110 of the present invention thus identifies tamper events without resorting to waxes, seals, and other physical objects that are destroyed and must be replaced. In particular, by determining whether the housing 106 is in the uninstalled position during the detection of an interruption of power to the power inputs 114, 116, the tamper protection circuit 110 identifies situations in which attempts are made to remove the housing 106 to disable the measurement circuit 108 and thus facilitate energy theft and distinguishes such situations from those in which a power outage has occurred. In contrast to prior art designs, the present invention requires no disposable elements such as sealing waxes that require special replacement materials. Instead, the present invention merely requires ordinary meter reading equipment (such as reed switch devices, key switch keys, or programming devices) to reconfigure meter once the tamper event information has been obtained by the utility.

Moreover, the embodiment of the present invention described above is of relatively reliable design as it includes little or no moving parts. Even if the mechanical switch is employed in the continuity circuit, the switch may be of relatively robust design because the switch need only be configured to be opened or closed based on whether the removable housing 106 is in the installed position.

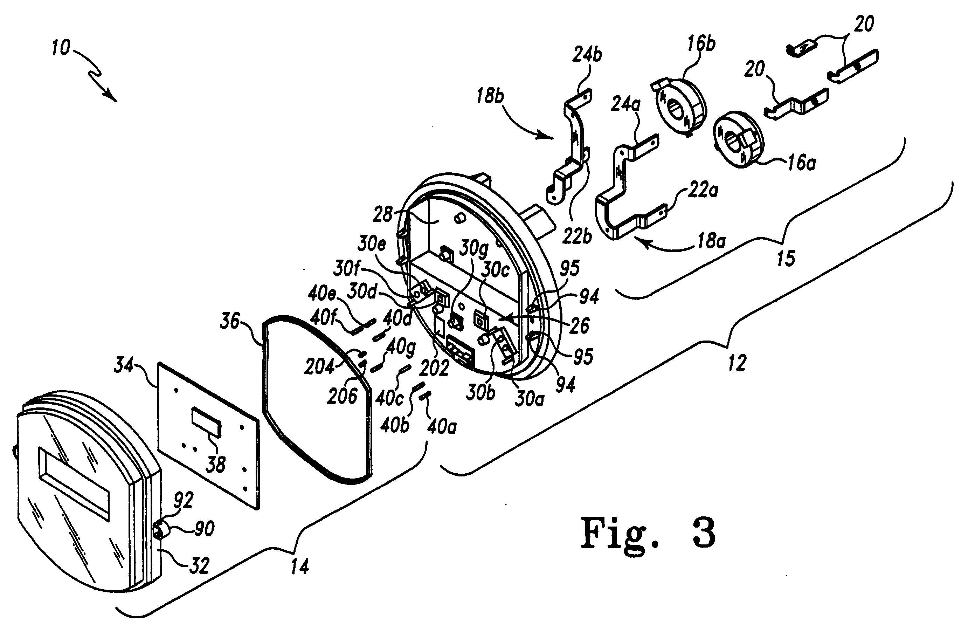

An alternative embodiment of the present invention is shown in Figs. 3 through 8. The alternative embodiment employs a tamper protection circuit according to the present invention in a modular utility meter 10. In general, the modular utility meter 10 is a device in which the source of energy consumption measurement signals is not located within the housing that contains the measurement circuit. Instead, the measurement circuit 42 of the modular utility meter 10 is located within a first housing 14a which houses or contains a portion of the modular utility meter 10 referred to as the *measurement module* 14. However, the source of energy consumption measurement signals, the voltage and current sensors 15, are located in a second housing 12a, which houses or supports a portion of the utility meter known as the *sensor module* 12.

The tamper protection circuit according to the present invention is particularly useful in the modular utility meter 10 because the measurement module 14 is intended to be readily removed and replaced. In other words, while the housing 106 of the modular utility meter 100 in Figs. 1 and 2 is rarely removed except in tamper events, the measurement module 14 of the meter 10 of Fig. 3 is designed to be removed to facilitate upgrades in service and/or metering capability. Accordingly, the use of destructive, single use, tamper detection devices such as wax seals is even less desirable in the interconnection between the measurement module 14 and the sensor module 12 of the modular meter 10 than in the interconnection between the housing 106 and the meter mounting device 118 of the meter 100 of Figs. 1 and 2.

Referring now to the modular utility meter 100, Fig. 3 shows an exploded view of an exemplary modular utility meter 10 according to the present invention. The modular utility meter 10 includes as its basic components the sensor module 12 and the measurement module 14. The revenue meter 10 is constructed as described below such that the measurement module 14 is removable from the sensor module 12. The exemplary revenue meter 10 is a type of meter known in the revenue metering industry as a 12S meter form. The meter form relates to the meter installation, for example, whether it is single phase or polyphase. In any event, it will be noted that the present invention is not limited to applications involving 12S meter forms, but may readily be incorporated into 2S, 3S, 4S, 8S/9S and other well known meter forms by those of ordinary skill in the art.

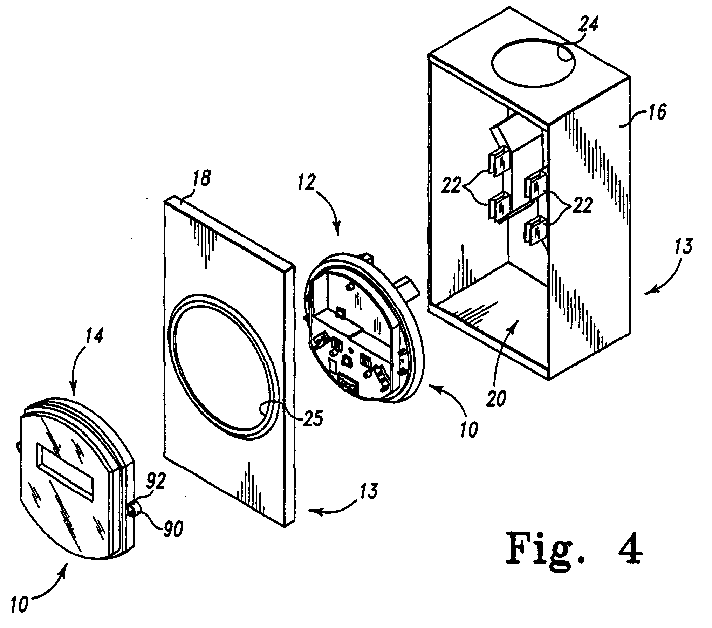

The housing 12a of the sensor module 12 houses voltage and current sensors 15, which according to the exemplary embodiment described herein, include first and second current transformers 16a and 16b, respectively, first and second current coils 18a and 18b, respectively, and one or more neutral blades 20. The first current coil 18a includes first and second ends defining first and second current blades 22a and 24a, respectively, to be received by the jaws of a compatible meter socket. (See Fig. 4) The second current coil 18b likewise includes first and second ends defining first and second current blades 22b and 24b, respectively, to be received by the jaws of the compatible meter socket. (See Fig. 4)

The first and second current transformers 16a and 16b, respectively, are preferably toroidal transformers having a substantially circular shape defined by a circular core. In the present embodiment, the first current transformer 16a has a turns ratio of N1 and the second current transformer has a turns ratio of N2. Using such toroidal current transformers, the first current coil 18a, when assembled, passes through the interior of the toroid of the first current transformer 16a. Preferably, the current transformer 16a is arranged such that the axial dimension of the current transformer 16a is substantially parallel to the axial dimension of the housing 12a. In other words, the current transformer 16a is horizontally-disposed within the sensor module housing 12a. The second current transformer 16b and the second current coil 18b are preferably arranged in a similar manner within the housing 12a. Accordingly, the second current transformer 16b is also horizontally disposed within the housing 12a. The use of horizontally disposed toroidal current transformers reduces the thickness and thus reduces the overall bulk of the meter 10.

The sensor module 12 further includes an electrically sale interface 26. The electrically sale interface 26 comprises a first interconnecting means for connecting to the measurement module 14. The electrically sale interface 26 also includes means for preventing physical contact of a human operator with potentially hazardous electrical signals present on at least a portion of the voltage and current sensors 15. Signal levels which are considered potentially hazardous are well-known. Different levels of potential hazard also exist. For example, signals capable of generating shock currents exceeding 70 milliamperes are possible burn hazards, while signals generating shock currents on the order of 300 milliamperes may constitute life threatening hazards. Furthermore, signals generating shock currents as low as 0.5 to 5 milliamperes are known to cause an involuntary startle reaction.

In revenue meters, including the modular utility meter 10 of Fig. 3, at least some of the sensor devices carry such potentially hazardous electrical signals. Specifically, any portion of the sensor module 12 that is electrically connected to the voltage and current signals from the power lines constitutes a life threatening hazard and must be isolated from human contact by the electrically safe interface 26. In the present embodiment, the current coils 18a and 18b are directly connected to the facility power lines and therefore must be isolated. By contrast, the current transformers 16a and 16b, do not necessarily carry life threatening currents because, as discussed later, the current transformers 16a and 16b are not directly coupled to the facility power lines. Accordingly, depending on the highest level of expected current flowing through the current transformers 16a and 16b, the current transformers 16a and 16b may or may not carry potentially hazardous electrical signals. In any event, however, the electrically safe interface 26 preferably prevents human contact with all of the voltage and current sensors 15 as a safety measure.

In the present embodiment, the means for preventing physical contact includes a top plate 28, and a plurality of sockets 30a, 30b, 30c, 30d, 30e, 30f and 30g. Each of the sockets 30a through 30g defines an opening in the top plate 28. Other than the openings defined by the sockets 30a through 30g, the top plate 28 preferably forms a complete barrier or wall between the space external to the housing 12a and the voltage and current sensors 15.

Alternatively, at a minimum, the top plate 28 operates to prevent human contact with the portions of the voltage and current sensors 15 that directly contact the power lines of the facility, and in particular, the current coils 18a and 18b.

In order to provide a complete barrier, the top plate 28 cooperates with the rest of the housing 12a and/or the meter mounting device or an alternative bottom structure that encloses the voltage and current sensors 15 from the side and bottom, not shown. Fig. 4, discussed below describes an exemplary meter mounting device that may be used to cooperate with the top plate 28 to enclose the voltage and current sensors 15.

In yet another alternative embodiment, the top plate 28 may be integral with a more extensive housing that includes more substantial side and/or bottom structures that cooperate to completely encase the voltage and current sensors 15.

Referring again to Fig. 3, the sockets 30a through 30g and their corresponding openings are preferably configured to prevent a human operator from physically contacting the electrically conductive portions of the socket. In particular, the openings defined by the sockets 30a through 30g have sufficiently diminutive proportions to prevent contact of a standard test finger with the electrically conductive portions of the sockets 30a through 30g. A standard test finger is a mechanical device used in the electrical industry to determine whether an electrical connection socket is safe from accidental contact by a human finger. One standard test finger is described in Underwriter's Laboratory, Inc., Standard For Safety of Information Technology Equipment Including Electrical Equipment Business UL-1950 (February 26, 1993).

In the present embodiment, the openings defined by the sockets 30a through 30g preferably have a first dimension, for example, the length, and a second dimension, for example, the width, wherein the first dimension has at least the same size as the second dimension, and the second dimension is less than 1/8 inch, thereby preventing substantial access of a human operator through the openings.

Also defined within the top plate 28 is a conductive trace 202. The conductive trace 202 fulfills the same functionality as that served by the conductor 132 of the meter 100 of Figs. 1 and 2. As will be discussed below, the conductive trace 202 provides an electrical connection between terminals 204 and 206 of a tamper protection circuit when the measurement module 14 is coupled to the sensor module 12. The conductive trace 202 preferably does not carry any potentially hazardous voltages because the conductive trace 202 is preferably not connected to anything within the sensor module 12 that is, in turn, coupled to the power lines. Accordingly, the conductive trace 202 does not necessarily have to be disposed within an electrically safe sockets such as the sockets 30a, 30b, etc.

The housing 14a of the measurement module 14 in the exemplary embodiment described herein includes a face cover 32, a printed circuit board 34, and a gasket 36. Mounted or otherwise affixed to the printed circuit board 34 are a display 38, a measurement circuit, not shown, and a tamper protection circuit, not shown. Fig. 7, discussed further below, shows in further detail a circuit block diagram of an exemplary embodiment of a measurement circuit 42 and a tamper protection circuit 230 that may readily be used in the measurement module 14 of Fig. 1. In general, however, the measurement circuit is operable to receive measurement signals and generate metering information therefrom. The measurement circuit is operably connected to provide at least some of the metering information to the display 38. The tamper protection circuit is a circuit that determines whether the measurement module housing 14a is installed onto the sensor module housing 12a upon detection of a power interruption to the measurement module.

A portion of the tamper protection circuit, first and second housing terminals 204 and 206, are shown in Fig. 3. The first and second housing terminals 204, 206 are advantageously disposed on the printed circuit board 34 to extend therefrom to contact the conductor 202 when the measurement module 14 is installed into the sensor module.

The measurement module 14 further includes second interconnecting means operable to cooperate with first interconnecting means (on the sensor module 12) to connect the measurement circuit of the printed circuit board 34 to the voltage and current sensors 15. For example, in the present embodiment, the measurement module 14 includes a plurality of plugs 40a through 40g that are received by the corresponding plurality of sockets 30a through 30g. The plurality of plugs 40a through 40g, when assembled, are electrically connected to the measurement circuit and physically connected to the printed circuit board 34.

Fig. 4 shows an installation configuration that includes the meter 10 and a meter box 13 comprising a mounting housing 16 and a cover 18. The mounting housing 16 is box-like in structure having an opening for receiving the cover 18 and a cabling opening 24 for receiving the power lines of the electrical system being metered, not shown. It will be appreciated that the mounting housing 16 need not be box-like in structure, and that any other suitable shape may be used, as long as there is an opening for receiving a cooperating meter box cover and a cabling opening. The mounting housing 16 further includes an interior 20. Within the interior 20 are located a plurality of jaws 22 constructed of electrically conductive material. When installed into a facility, the plurality of jaws 22 are electrically connected to the power lines of the electrical system of the facility.

The plurality of jaws 22 receive and provide electrical connection to the current coil blades 22a, 24a, 22b and 24b (see Fig. 1) as well as the neutral blade or blades 20. The relationship of the jaws and the blades 22a, 24a, 22b, and 24b also define the alignment of the sensor module 12 within the mounting housing 16. Once the blades 22a, 24a, 22b, and 24b (see Fig. 3) are engaged with the plurality of jaws 22 (Fig. 4), the sensor module 12 is installed within the interior 20 of the mounting housing 16. The cover 18 is then installed onto the mounting housing 16. The cover 18 includes a meter opening 25 having a perimeter defined by the perimeter of the sensor module 12. Preferably, the perimeter of the meter opening 25 has substantially the same shape and is slightly smaller than the perimeter of the sensor module 12 such that the sensor module 12 cannot be removed when the cover 18 is engaged with the mounting housing 16.

Once the cover 18 is installed, the measurement module 14 in the present embodiment is placed in engagement with the sensor module 12 through the meter opening 25 of the meter box cover 18. When in engagement, the plugs 40a through 40g of the measurement module 14 are electrically connected to the sockets 30a through 30g, respectively, of the sensor module 12. Once the measurement module 14, the cover 18, the sensor module 12, and the mounting housing 16 are all assembled as described above, the meter 10 (*i.e.*, the sensor module 12 and the measurement module 14) performs energy consumption metering operations on the electrical system of the facility.

It is noted that if the measurement module 14 is removed from the sensor module 12, the facility to which the meter 10 is connected will continue to receive electrical power service, but will not be charged for such power usage. The facility will not be charged for such power usage because the billing information is generally obtained from the accumulated energy consumption information in the measurement module 14, and the measurement module 14 does not obtain accumulated energy consumption information when the measurement module 14 is removed from the sensor module 12. Accordingly, a potential method of meter tampering is to remove the measurement module 14 from the sensor module 12 for a few hours a day, or for one or more days, and then replace the measurement module 14 before utility service provider personnel comes to read the meter.

The tamper protection arrangement of the present invention, discussed further below, operates to record and/or communicate an indication that the measurement module 14 has been removed from the sensor module 12, which may indicate a tamper event. Utility personnel can readily remove the tamper record and/or indication with ordinary equipment, such as through a reed switch, as discussed further below. Accordingly, the tamper indication may be easily removed after a utility technician removes the measurement module 14 for legitimate reasons.

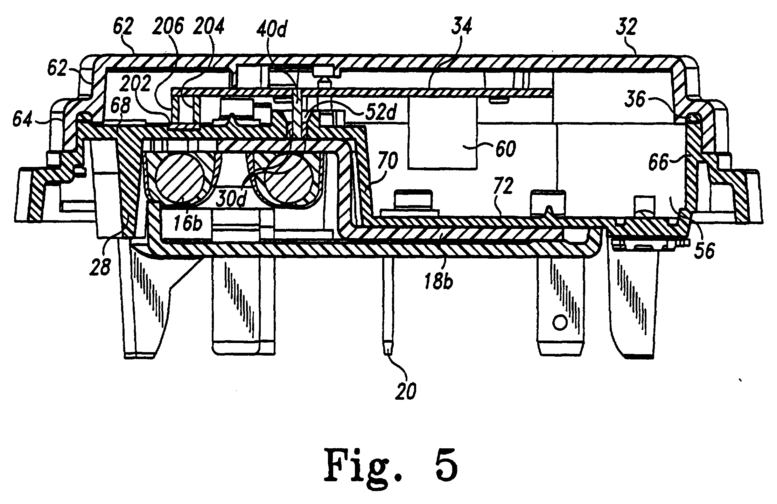

Fig. 5 shows a side view cutaway of the meter 10 wherein the measurement module 14 is assembled or installed onto the sensor module 12. The face cover 32 of the measurement module 14 includes a cylindrical portion 62 and an annular skirt 64. The top plate 28 of the sensor module 12 is defined in part by an annular ridge 66. The annular ridge 66 is received by a space defined in between the annular skirt 64 and the cylindrical portion 62 of the meter cover 32. The top plate 28 is further defined by a shelf 68 that is substantially flat and abuts, in part, the cylindrical portion 62. The shelf 68 constitutes approximately one-half of the top plate 28. The other half of the top plate 28 consists of a depression 56 defined by a drop 70, a bottom 72 and a portion of the annular ridge 66. The drop 70 defines the change in depth between the shelf 68 and the bottom 72.

The depression 56 defines a space that allows for large components on the printed circuit board 34 to extend downward from the measurement module 14 below the cylindrical portion 62. In the illustrated example, components of a power supply 60 extend below the cylindrical portion 62 to occupy at least a portion of the depression 56. The two level configuration of the top plate created by the depression 56 of the sensor module 12 more efficiently utilizes the space within the meter 10.

As discussed above, the top plate 28 also includes a plurality of openings, illustrated in Fig. 5 by the exemplary opening 52d. The opening 52d corresponds to the socket 30d, and similar openings exist that correspond to each of the other sockets 30a, 30b, 30c, 30e, 30f and 30g. (See Fig. 1) The opening 52d is preferably slightly conical to allow for alignment adjustment of the plug 40d during assembly of the measurement module 14 onto the sensor module 12. The socket 30d, which may suitably be a spring loaded terminal, is electrically connected to the current coil 18b for the purposes of providing a connection to the phase C voltage measurement, as discussed above in connection with Fig. 3.

Fig. 5 further shows the plug 40d connected to the circuit board 34 and inserted through the opening 52d and into the socket 30d. The socket 30d physically engages the plug 40d in such a manner as to provide an electrical connection therebetween. The plug 40d may suitably be an ordinary conductive pin.

The first and second housing terminals 204 and 206 on the printed circuit board 34 of the measurement module 14 extend downward to the conductive trace 206 on the sensor module 12. Accordingly, when the measurement module 14 is in the installed position, the first and second housing terminals 204 and 206 are electrically coupled through the conductive trace 206. As will be discussed further below, the tamper protection circuit determines whether the measurement module is in the installed position based on whether there is circuit continuity between the housing terminals 204 and 206.

It can thus be seen by reference to Figs. 3, 4 and 5, that the electrically safe interface or top plate 28, when fitted to a cooperating meter housing, provides a substantially solid barrier between a human operator or technician and the current and voltage sensing devices when the measurement module 14 is removed for repair or replacement. It will be appreciated that other interconnection means may be employed in the sensor module 12 and measurement module 14 that will also provide an electrically sale interface. For example, wireless means may be used as the interconnection means. Such wireless means could provide voltage and current measurement signals from the sensor module 12 to the measurement module 14. For example, the measurement module 14 could include sensitive electric and magnetic field sensors that obtain voltage and current measurement information from electromagnetic radiation from the current coils 18a and 18b. Likewise, optical communication means may be used to provide measurement signal information from the sensor module 12 to the measurement module. In any case, the electrically safe interface would typically include a barrier such as the top plate 28 that prevents physical access by a human operator to the current coils 18a and 18b and other dangerous portions of the sensor module 12 when the measurement module 14 is removed.

To fully obtain the benefits of modularity, it is necessary to address calibration issues in the design of the meter 10. Specifically, the sensor portion 12 of the meter must have a calibration feature that allows it to be used in connection with any suitable measurement portion. In non-modular meters, the measurement circuit is often specifically calibrated for use with a particular voltage and current sensors. The reason for the specific calibration is that there can be large variations in signal response of each of the voltage and current sensors. In particular, the current sensing devices, such as current transformers, often have a widely variable signal response. The signal response of commonly available current transformers varies widely in both magnitude and phase response.

The signal response of such current transformers varies to a much greater extent than the energy measurement accuracy requirements of the meter. In other words, while the current transformer signal response may vary as much as 10%, the overall accuracy of the meter is required to be much less than 10%. Accordingly, compensation must be made for the variance, or tolerance, of the current sensing devices to ensure that the ultimate energy measurement accuracy of the meter is within acceptable tolerances. The compensation is typically carried out in the prior art by adjusting or calibrating the measurement circuit during manufacture to account for the signal response characteristics of the particular current sensing devices that will be used in a particular meter unit. In other words, each measurement circuit is custom-calibrated for each meter.

A truly modular meter, however, cannot require such extensive unit-specific calibration. Instead, the modular components must be readily interchangeable. Accordingly, referring again to Fig. 3, the sensor module 12 is pre-calibrated for modularity, such that the sensor module 12 may be coupled with any measurement module 14 without requiring unit-specific calibration of that measurement module 14.

To this end, the sensor module 12, and specifically the voltage and current sensors 15 are pre-calibrated such that the voltage and current sensors has a signal response within a tolerance of a predefined signal response that is no greater than the tolerance of the energy measurement accuracy of the meter 10. The energy measurement accuracy of the meter 10 is defined as the accuracy of the measured energy consumption with respect to the actual energy consumption of the facility. Thus, if the tolerance of the energy measurement accuracy of the meter is required to be 0.5%, then the difference between the measured energy consumption and the actual energy consumption will not exceed 0.5%. In such a case, the tolerance of the signal response of the voltage and current sensors will be no more than, and typically substantially less than, 0.5%. As a result, the measurement module 14 may readily be replaced with another measurement module without requiring specific calibration of the replacement measurement module.

The pre-calibration of the voltage and current sensors 15 may be accomplished using careful manufacturing processes. The primary source of variance in the signal response of the voltage and current sensors 15 is the signal response of the current transformers 16a and 16b. Generally available current transformers are prone to variance in both magnitude and phase angle signal response. Accordingly, pre-calibration involves using current transformers that are manufactured to perform within the required tolerances. To this end, the current transformers 16a and 16b are manufactured using a high permeability core material, which reduces phase angle variance in the signal response. Moreover, the current transformers 16a and 16b are manufactured such that the actual number of turns is closely controlled. Close manufacturing control over the number of turns in the current transformers 16a and 16b produces sufficient consistency in the magnitude signal response to allow for interchangeability.

Alternatively, if controlling the number of turns during initial manufacturing is not desirable for cost reasons, then turns may be added or removed after manufacturing to achieve the desired signal response. For example, it may be more cost effective to buy wide tolerance commercially available current transformers and adjust the number of turns than to have sufficiently narrow tolerance current transformers specially manufactured.

Figs. 3,4, and 5 thus describe a modular utility meter 10 that performs metering functions that allows for replacement and upgrade of the measurement module 14 without replacing the entire meter. By employing the tamper protection circuit of the present invention as discussed below, replacement of the measurement module 14 may be accomplished without destroying mechanical tamper sealing arrangements and thus having to install new mechanical sealing arrangements.

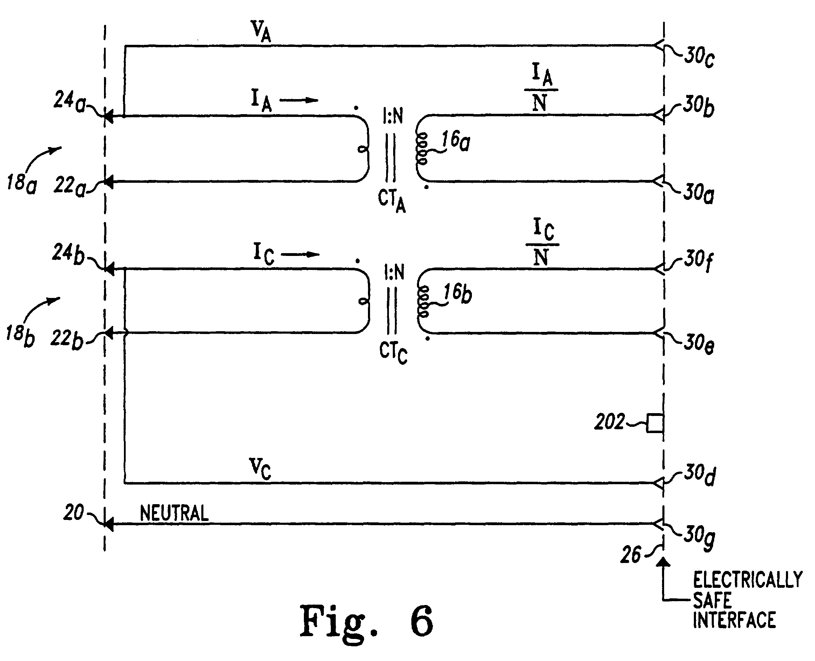

Figs. 6 and 7 show circuit block diagrams of the modular utility meter 10. Fig. 6 shows a circuit block diagram of the sensor module 12. Fig. 7 shows a circuit block diagram of the measurement module 14. It will be noted that the circuit diagrams of Figs. 6 and 7 are given by way of example only. Those of ordinary skill in the art may readily employ their own circuits that perform the same functions described generally below and still benefit from many of the advantages provided by inclusion of the tamper protection circuit according to the present invention within a measurement module of a modular meter.

Referring now to the circuit block diagram of the sensor module 12 and Fig. 7, the sockets 30a and 30b provide a connection to the first current transformer 16a, the sockets 30e and 30f provide a connection to the second current transformer 16b, the socket 30c provides a connection to the first current coil 18a, the socket 30d provides a connection to the second current coil 18b, and the socket 30g provides a connection to one or more of the neutral blades 20.

Fig. 7 shows a circuit block diagram of the measurement circuit 42 and associated display circuit 38 for use in the measurement module 14. The measurement circuit 42 includes a watt measurement integrated circuit ("IC") 44, a processor 48, a non-volatile memory 50, a power fail detector 208, a back-up power supply 210, and a reed switch detector 213.

Plugs 40a, 40b, 40c, 40d, 40e, and 40f are each connected to the watt measurement IC 44 through various input circuits. In particular, the plugs 40a and 40b are connected to the watt measurement IC 44 through a phase A current input circuit 212, the plugs 40e and 40f are connected to the watt measurement IC through a phase C current input circuit 214, the plug 40c is connected to the watt measurement IC 44 through a phase A voltage input circuit 216, and the plug 40d is connected to the watt measurement IC 44 through a phase C voltage input circuit 218.

The phase A current input circuit 212 is a device for obtaining a scaled signal indicative of the line current waveform on phase A. To this end, the phase A current input circuit 212 is connected across a line resistor R1 that is series connected between the plug 40a and the plug 40b. Likewise, the phase C current input circuit 214 is a device for obtaining a scaled signal indicative of the line current waveform on phase C. To this end, the phase C current input circuit 214 is connected across a line resistor R2 that is series connected between the plug 40e and the plug 40f. The outputs of the phase A and phase B current input circuits 212 and 214 are provided to the watt measurement IC 44.

The phase A voltage input circuit 216 is a voltage divider network tapped off of the connection to plug 40c. Similarly, the phase C voltage input circuit 218 is a voltage divider network tapped off of the connection to the plug 40d. The power supply 60 is a device the receives AC input line voltage and generates a dc bias voltage Vcc therefrom. Such power supplies are well known in the art. The power input to the power supply 60 is preferably tapped off of the connection to the plug 40d. The outputs of the phase A and phase C voltage input circuits 216 and 218 are provided to the watt measurement IC 44.

The watt measurement IC 44 is a device that receives energy consumption measurement signals representative of voltage and current signals in an electrical system and generates energy consumption data therefrom. In the exemplary embodiment described herein, the watt measurement IC 44 may suitably be the conversion circuit 106 described in U.S. patent application no. 08/690,973 or the conversion circuit 106 described in U.S. patent application no. 08/881,140, both of which are assigned to the assignee of the present invention and incorporated herein by reference.

Alternatively, the watt measurement IC 44 may be replaced by one or more discrete circuits capable of carrying out the same function of generating energy consumption information from the voltage and current measurement signals. For example, the watt measurement IC 44 may suitably be replaced by the first and second watt measurement ICs (labeled 44 and 46) described in the U.S. patent application serial no. 08/862,844, which is assigned to the assignee of the present invention and incorporated herein by reference.

In any event, the watt measurement IC 44 is further operably connected to the processor 48 through a bus structure 220. The bus structure 220 consists of one or more serial and or parallel busses that allow for data communication between the processor 48 and the watt measurement IC 44. In general, the watt measurement IC 44 provides energy consumption data to the processor 48 and the processor 48 provides control and calibration data to the watt measurement IC 44.

The processor 48 is further operably connected to the non-volatile memory 50, the display circuit 38, the reed switch detector 213 and the power fail detector 208. The power fail detector 208 is a device, such as that described in connection with Figs. 1 and 2, that obtains information regarding whether there is a power interruption to the power inputs to the measurement module 14. The power inputs to the measurement module 14 are 40d and 40g, which provide the connection to external line power to the power supply 60.

In the embodiment described in connection with Figs. 3 through 8, the power fail detector 208 is a circuit that detects the bias voltage at the output of the power supply 60a, and provides a power fail signal that signifies that the base voltage has fallen below a predetermined threshold. It is preferable that the power fail signal has an inverted logic characteristic such that the power fail detector 208 provides a high logic voltage to the processor 48 when the bias voltage is above the threshold and conversely provides a low logic voltage when the bias voltage is below the threshold. The power fail detector 208 may suitably comprise a circuit that is similar to the power fail detection circuit 111 of Figs. 1 and 2, discussed above.

The back-up power supply 210 is a device and or circuit that provides back-up bias power, also provided through the connection Vcc, to the various circuit elements in the event that the power supply 60 stops generating sufficient bias power. To this end, the back-up power supply 210 may suitably include a battery circuit that generates a voltage of at least approximately 1 volt less than the bias voltage of the power supply 60. In this manner, the battery circuit of the back-up power supply 210 only provides power to the measurement circuit 42 when the bias voltage of the power supply 60 is substantially low or missing.

The reed switch detector 213 is a device that is configured to be responsive to a special magnetic reed switch typically used by utility personnel to manipulate utility meters without connecting to the utility meter circuitry. Reed switches are often employed to trigger diagnostic displays and other features that are designed specifically for use by utility personnel. The reed switch detector 213 is configured as is well known in the art to signal to the processor 48 that a magnetic reed switch, not shown, has be passed in close proximity signifying that the processor 48 should perform a particular operation. In the embodiment described herein, the reed switch detector 213 provides a signal to the processor 48 signifying to the processor 48 that a tamper flag or indication, if there is one, has been noted by utility personnel and that the tamper indication may be removed.

The tamper protection circuit 230 in the modular utility meter 14 comprises the processor 48, the power fail detector 208, and the first and second housing terminals 204 and 206.

As discussed above, the present embodiment is intended for use with a 12S meter form that is generally associated with a three-wire network configuration. A three-wire network configuration, as is well known in the art, includes a phase A power line, a phase C power line, and a neutral line. The present invention, however, is in no way limited to use in a three wire network configuration. The concepts described herein may readily be implemented in meters used in other configurations, including single phase and other polyphase configurations.

In operation, the plurality of jaws 22 provide the phase A power line signal, in other words, the phase A voltage and current, across the blades 22a and 24a of the first current coil 18a (see Fig. 3). Similarly, the plurality of jaws 22 provide the phase C power line signal across the blades 22b and 24b of the second current coil 18b (see Fig. 3). Referring to Fig. 7, the phase A current flows from the blade 24a through the first current coil 18a to the blade 22a. The first current coil 18a imposes a scaled version of the current, referred to herein as the phase A current measurement signal, on the first current transformer 16a. The phase A current measurement signal is approximately equal to the current flowing through the current coil 18a scaled by a factor of N1, where N1 is the turns ratio of the current transformer 16a. The phase A current measurement signal is provided to the sockets 30a and 30b. The first current coil 18a is further operably connected to provide the phase A voltage to the socket 30c.

Similar to the phase A current, the phase C current flows from the blade 24b of the second current coil 18b to the blade 22b. The phase C current is imposed onto the second current transformer 16b, thereby causing the second current transformer 16b to generate a phase C current measurement signal. The phase C current measurement signal is approximately equal to the phase C current scaled by a factor of N2, where N2 is the turns ratio of the second current transformer 16b. The turns ratios N1 and N2 of the current transformers 16a and 16b, respectively, are typically substantially similar and preferably equal. However, manufacturing tolerances may result in slight differences in the turns ratios N1 and N2. In any event, the second current transformer 16b provides the phase C current measurement signal to the sockets 30e and 30f. The second current coil 18b is also operably connected to the socket 30d for the purposes of providing the phase C voltage thereto. The neutral blade 20 provides a connection between the neutral power line and the socket 30g.

When the measurement module 14 is in the installed position, such as is shown in Fig. 5, the modular utility meter 10 operates the manner described below to generate metering information including accumulated energy consumption information.

In particular, the sockets 30a and 30b (Fig. 6) provide the phase A current measurement signal to the plugs 40a and 40b, respectively, of the measurement module 14 (Fig. 7). Likewise, the sockets 30e and 30f (Fig. 6) provide the phase C current measurement signal to the plugs 40e and 40f, respectively, of the measurement module 14 (Fig. 7). The sockets 30c and 30d (Fig. 6), provide, respectively, the phase A and phase C voltage measurement signals to the plugs 40c and 40d (Fig. 7). The neutral socket 30g (Fig. 6) provides a neutral connection to the plug 40g of Fig. 7.

Referring again to Fig. 7, the measurement circuit 42 generates metering information within the measurement module 14 based on the received measurement signals. It will be noted that the metering information generated by the measurement circuit 42 may include far more than accumulated energy consumption information. For example, the metering information may include information useful in one or more advanced features, including demand metering, time or use metering, service type recognition, diagnostics, or the like.

In any event, the plugs 40a and 40b provide the phase A current measurement signal to the watt measurement IC 44 through the phase A current input circuit 212. The phase A current input circuit 212 preferably converts the phase A current measurement signal to a voltage signal having a magnitude and phase that is representative of the phase A current. The socket 40c provides the phase A voltage measurement signal through the phase A voltage input circuit 216 to the watt measurement IC 44.

The plugs 40e and 40f similarly provide the phase C current measurement signal to the watt measurement IC 44 through the phase C current input circuit 214. The phase C current input circuit 214 preferably converts the phase C current measurement signal to a voltage signal having a magnitude and phase that is representative of the phase C current. The socket 40d provides the phase C voltage measurement signal through the phase C voltage input circuit 218 to the watt measurement IC 44.

The socket 40d further provides the phase C voltage to the power supply 60. The power supply 60 is further connected to the neutral plug 40g and operates to provide a bias voltage Vcc to each of the functional block circuits within the measurement module 14. In particular, the power supply 60 operates to convert the input AC electrical power to a DC bias voltage that is used to power the various elements of the measurement circuit 42, including the watt measurement IC 44, the processor 48, the display circuit 38, and the non-volatile memory 50. The power supply 60 provides the generated DC bias voltage at its output 60a which is then provided through a protection diode D1 to various elements of the measurement circuit 42 as the bias voltage Vcc.

The voltage Vcc provided by the power supply 60 exceeds the voltage generated by the battery circuit in the back-up power supply 210. As a result, the back-up power supply 210 does not provide any power to the measurement circuit 42. In addition, the voltage generated at the power supply output 60a exceeds the threshold voltage of the power fail detector 208. As a result, the power fail detector 208 does not provide the power fail signal to the processor 48.

Returning again to the measurement signals, the watt measurement IC 44 receives the phase A and phase C voltage and current measurement signals and generates energy consumption data therefrom. To this end, the watt measurement IC 44 preferably samples, multiplies and accumulates the measurement signals as is known in the art to generate watt data, VA data, and/or VAR data. See, for example, United States patent application serial no. 08/690,973 or United States patent application serial no.08/881,140, as discussed above, for a description of such operations.

The processor 48 then obtains the watt data, VA data, and/or VAR data and further processes the data to provide metering information therefrom. For example, the processor 48 may convert the energy consumption information into standard units and generate metering information representative of energy consumption information accumulated over time. The metering information is communicated externally through the display 38. Alternatively or additionally, the metering information may be communicated through an external communication circuit, not shown.

The tamper protection circuit 230 of the modular utility meter 10, similar to the tamper protection circuit 110 of Fig. 1, commences operation upon detection of an interruption of power to the power inputs, which in Fig. 7 comprise the plugs 40d and 40g.

If power is interrupted to the plugs 40d and 40g, then the voltage generated by the power supply 60 at the output 60a falls. When the generated voltage at the output 60a of the power supply falls below a threshold, then the power fail detector 208 generates a (low logic) power fail signal. Moreover, once the voltage Vcc generated by the power supply 60 falls below the voltage level of the back-up power supply 210, the back-up power supply 210 starts to provide the bias voltage Vcc to the components of the measurement circuit 42.

When the processor 48 receives the power fail signal, it determines whether there is continuity between the first housing terminal 204 and the second housing terminal 206. To this end, the first housing terminal 204 is typically connected to an output 48a of the processor 48 that produces a high logic voltage and the second housing terminal 206 is connected to an input 48b of the processor 48. In such a case, the processor merely determines whether there is a high logic voltage at the input 48b.

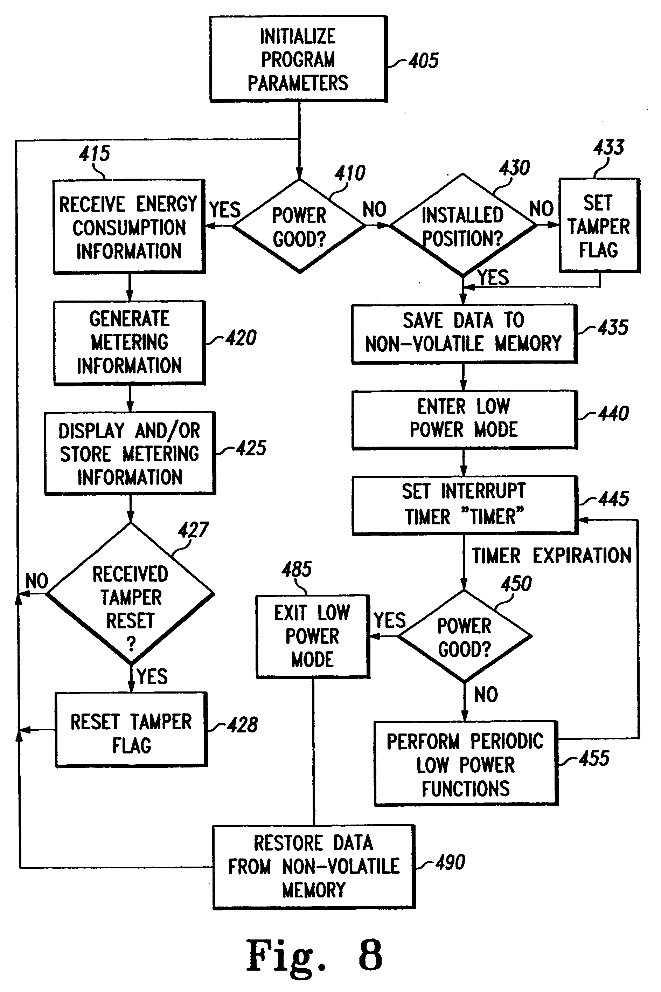

In any event, if there is continuity, then the processor 48 determines that the measurement module 14 is still in the installed position. If not, however, then the processor 48 determines that measurement module 14 is in the uninstalled position and sets a tamper flag. The processor 48 may then enter a low power mode to conserve the back-up power supply 210. Further detail regarding the operation of the processor 48 is provided below in connection with Fig. 8.

If the tamper flag is set, then the processor 48 may display a tamper indicator on the display circuit 38, typically after the power is restored to the plugs 40d and 40g by reinstallation of the measurement module 14. The tamper indicator and tamper flag may only be reset through proper activation of the reed switch detector 213. It is presumed that the operation of the reed switch detector 213 can only occur through the actions of a utility technician who will record and report the tamper event.

Fig. 8 shows a flow diagram of an exemplary set of operations of a processor, such as the processor 48 that may be used in a meter according to the present invention. In particular, the operations shown in Fig. 8 and described below may suitably be carried out by the processor 48 of Fig. 7, but may in any event be carried out by a processor that is part of a meter according to the present invention that includes, among other things, a tamper protection circuit.

The flow diagram includes the operations of the controller 48 in normal metering operations as well as operations relating to tamper protection and power outage. Normal metering operations of the processor 48, such as those that relate to performing metering calculations, are highly generalized and are only illustrated to place the operations relating to tamper detection in context.

Step 405 illustrates the first step, which is executed upon initial power up of the meter 10. The initial power up may occur when the meter 10 is first connected to the power lines ØA, ØC, and N. In step 405, the processor 48 initializes program parameters and performs other start-up operations. Thereafter, in step 410, the processor 48 determines whether the AC electrical power is present. To this end, the processor 48 determines whether a power fail signal indicative of a power interruption is being provided by the power failure detector 208.

If, in step 410, the processor 48 determines that AC electrical power is present, the processor 48 proceeds to execute step 415. In step 415, the processor 48 receives the energy consumption data from the watt measurement IC 44. Thereafter, in step 420, the processor 48 generates metering information. To this end, the processor 48 may convert the raw energy consumption data received from the watt measurement IC 44 to standardized units for storage and display. Such operations are well known. The processor 48 may in any event generate metering information including, but not limited to, accumulated watt-hrs, VA-hrs, and VAR-hrs, as well as RMS voltage and current information. The processor 48 may of course generate standard metering quantities that are not necessarily displayed.

Once the metering information is generated in step 420, the processor 48 provides the metering information to internal memory and/or the display 38 in step 425. Then, in step 427, the meter determines it has received a tamper reset input. In particular, as discussed above, if a tamper flag has been previously set (see steps 430 and 433, discussed below), a facility is provided by which a utility technician may reset the tamper flag once it has been noted by the technician. In the exemplary embodiment described above, the facility for resetting the tamper flag is a reed switch, not shown. Accordingly, the processor 48 in step 427 determines whether a tamper flag reset command has been detected via the reed switch detector 213.

If the processor 48 in step 427 determines that a tamper flag reset indication has been received, then the processor 48 resets the tamper flag in step 428 and then returns to step 410. If not, however, then the processor 48 proceeds directly from step 427 to step 410 and continues with metering operations.

In alternative arrangements, the tamper flag may be transmitted via a communication facility within the meter, thereby allowing the processor of the meter to reset the flag automatically upon confirmation that information representative of the tamper event has been communicated to a remote facility. In such cases, steps 427 and 428 as described above would not be necessary.

The flow of steps 410 through 428 illustrate the normal operations of the processor 48 when AC electrical power is present. It will be noted that the processor 48 may suitably perform several other functions during normal operations, which are not central to the operation of the present invention, and therefore are omitted for purposes of clarity of exposition.

In any event, if the processor 48 determines in the execution of the step 410 that the AC electrical power has been interrupted, then the processor 48 proceeds to step 430. In step 430, the processor 48 determines whether the housing (measurement module 14) is in the installed position. As discussed above in connection with Fig. 7, the processor 48 determines whether the measurement module 14 is installed by determining whether a high logic voltage is present on the second housing terminal 206.

If, in step 430, it is determined that a high logic voltage is not present on the second housing terminal 206, then the processor 48 sets a tamper flag = 1 in step 433, and then proceeds to step 435. If, however, it is determined that a high logic voltage is present at the second housing terminal 206, then the processor proceeds directly to step 435 without setting the tamper flag equal to one.

In step 435, the processor 48 transfers certain critical data, including the value of the tamper flag, to the non-volatile memory 50. In particular, certain of the metering information must be preserved through the power outage as well as in the event that the back-up power supply fails. Such information often will include the accumulated energy consumption information as well as time stamp information. The tamper flag value is also stored such that the tamper record is preserved through the loss of power to the processor 48. In any event, the processor 48 transfers such information from its internal registers, or from other memory, to the non-volatile memory 50.

Thereafter, in step 440, the processor 48 enters low power mode. In low power mode, the processor 48 clock speed is reduced as is well known in the art, and the processor 48 may turn off certain internal and/or external circuitry to conserve power.

Then, in step 445, the processor 48 sets and interrupt timer TIMER. Until the expiration of TIMER, the processor 48 does not perform other functions, thereby conserving power. Upon expiration of TIMER, the processor 48 in step 450 determines whether the power fail signal indicates that AC electrical power has been restored. If not, then the processor 48 in step 455 increments a clock counter within the processor 48. The clock counter tracks the time during the AC electrical power interruption. The clock counter may suitably be stored in memory internal to the processor 48, the non-volatile memory 50, or other memory, not shown. In addition, the processor 48 in step 455 performs other periodic low power functions, the specifics of which are not germaine to the invention described herein. Thereafter, the processor 48 returns to step 445 to continue low power operations.

If, however, in step 450, the processor 48 determines that the AC electrical power has been restored, then the processor 48 executes step 485. In step 485, the processor 48 exits low power mode. In particular, the processor 48 may suitably switch to the higher speed clock used for the "normal" metering operations. In addition, the processor 48 resets and/or restarts other functions and circuits that operate during normal metering operations.

Thereafter, in step 490, the processor 48 restores the data stored in non-volatile memory 50 to the registers and other locations in which the data is stored during "normal" operations of the meter 10. The condition of the tamper flag may suitably be returned to a register within the processor. After step 490, the processor 48 returns to step 410. From step 410, the processor 48 operates as described above. It is noted that if the tamper flag is set, the processor 48 may suitably provide a visual indication to the display, for example, during step 425.

Thus, the processor 48 may serve the purposes of controlling metering operations and operating as a portion of the tamper protection circuit. While many advantages of the present invention may be accomplished without using the processor 48 for both purposes, such use can reduce component cost and meter size.

It will be appreciated that the above described embodiments are given by way of example only, and that those of ordinary skill in the art may readily devise their own implementations that incorporate the principles of the present invention and fall within the spirit and scope thereof.

## Claims

1. An electrical utility meter for measuring a quantity of electrical power consumed by a load, the electrical utility meter comprising:
a source of energy consumption measurement signals;
a removable housing having an installed position and an uninstalled position, the housing having a power input for receiving electrical power from a power line when in the installed position;
a measurement circuit secured to the housing and coupled to the source of energy consumption measurement signals to receive energy consumption measurement signals therefrom when the housing is in the installed position, the measurement circuit configured to generate energy consumption information based at least in part on said measurement signals; and
a tamper detection circuit secured to the housing and operable to detect an interruption of the electrical power to the housing input and determine whether the housing is in the uninstalled position when an interruption of the electrical power to the housing input is detected.

2. The electrical utility meter of claim 1 wherein a processor comprises at least a portion of said measurement circuit and said tamper detection circuit.

3. The electrical utility meter of claim 1 wherein the source of electrical power consumption information is secured to the housing and is operable to generate the power consumption information when the housing is in the installed position.

4. The electrical utility meter of claim 1 wherein the source of electrical power consumption information is secured to a second housing, and wherein the housing is in the installed position when the housing is coupled to the second housing and the housing is in the uninstalled position when the housing is decoupled from the second housing.

5. The electrical utility meter of claim 1 further comprising a power supply secured to the housing, the power supply operable to receive electrical power from the input and provide bias power to at least a part of the measurement circuit and at least a part of the tamper detection circuit.

6. The electrical utility meter of claim 5 wherein the tamper detection circuit further includes a connection to an output of the power supply and is further operable to detect an interruption of electrical power to the input using said connection.

7. The electrical utility meter of claim 1 wherein the tamper detection circuit includes a processor and wherein the processor is operable to set a flag upon determining that the housing is in the uninstalled position upon detection of an interruption of electrical power to the housing input.

8. The electrical utility meter of claim 7 wherein the tamper detection circuit further comprises a non-volatile memory for storing the set flag.

9. The electrical utility meter of claim 7 further comprising a visible indicator secured to the housing and operably coupled to the processor, the visible indicator configured to provide a visible indication of the set flag when the housing is installed.

10. The electrical utility meter of claim 7 further comprising a display operably coupled to the measurement circuit and to said processor, said display operable to
display information representative of the metering information; and
display a visible indication of the set flag when the housing is installed.

11. In an electrical utility meter for measuring a quantity of electrical power consumed by a load, the electrical utility meter comprising a source of energy consumption measurement signals, a removable housing having an installed position and an uninstalled position, the housing having a power input for receiving electrical power from a power line when in the installed position and a measurement circuit secured to the housing and coupled to the source of energy consumption measurement signals to receive energy consumption measurement signals therefrom when the housing is in the installed position, the measurement circuit configured to generate energy consumption information based at least in part said energy consumption measurement signals,
a tamper detection circuit secured to the housing and operable to detect an interruption of the electrical power to the housing input and determine whether the housing is in the uninstalled position when an interruption of the electrical power to the housing input is detected.

12. The tamper detection circuit of claim 11 further comprising a processor.

13. The tamper detection circuit of claim 12 wherein the processor also comprises at least a portion of the measurement circuit.

14. The tamper detection circuit of claim 12 wherein the processor includes a connection to a power supply output of a power supply, said power supply obtaining electrical power from said housing input when said housing is in the installed position, and wherein said processor detects an interruption of the electrical power to the housing input based on said connection.

15. The electrical utility meter of claim 12 wherein the processor is operable to set a flag upon determining that the housing is in the uninstalled position upon detection of an interruption of electrical power to the housing input.

16. The tamper detection circuit of claim 12 further comprising an installation continuity circuit, the installation continuity circuit including
a first housing terminal coupled to a source of bias voltage, said first housing terminal adapted to be in electrical contact with a first portion of an electrically conductive element;
a second housing terminal coupled to the processor, said second housing terminal adapted to be in electrical contact with a second portion of the electrically conductive element; and
wherein said processor is operable to determine that said housing is in the uninstalled position based on whether the bias voltage is present on the second housing terminal.

17. The tamper detection circuit of claim 12 further comprising an installation continuity circuit, the installation continuity circuit including
a first housing terminal coupled to a source of bias voltage,
a second housing terminal coupled to the processor,
wherein the first housing terminal is electrically coupled to the second housing terminal when the housing is in the installed position, and wherein the first housing terminal is electrically decoupled from the second housing terminal when the housing is in the uninstalled position; and
wherein said processor is operable to determine that said housing is in the uninstalled position based on whether the bias voltage is present on the second housing terminal.

18. The tamper detection circuit of claim 17 wherein:
the first housing terminal is adapted to be in electrical contact with a first portion of an electrically conductive element only when the housing is in the installed position; and
a second housing terminal is adapted to be in electrical contact with a second portion of the electrically conductive element only when the housing is in the installed position.

19. An electronic utility meter coupled to an electrical system of a facility, the electronic utility meter comprising:
a) a sensor module configured to connect to the electrical system, said sensor module including voltage and current sensors, said voltage and current sensors operable to receive voltage and current signals from the electrical system and generate measurement signals therefrom;
b) a measurement module including a measurement circuit operable to receive measurement signals and generate energy consumption data therefrom, said measurement module including a device for communicating information relating to the energy consumption data, said measurement module operable to be coupled to the sensor module to connect the measurement circuit to the voltage and current sensors, said measurement module operable to be coupled to a source of electrical power when the measurement module is coupled to the sensor module; and
c) a tamper detection circuit secured to the measurement module and operable to detect an interruption of the electrical power to the measurement module and determine whether the measurement module is de-coupled from the sensor module when an interruption of the electrical power to the measurement module is detected.

20. The electronic utility meter of claim 19 wherein the tamper detection circuit further comprises a processor.

21. The electronic utility meter of claim 20 wherein the processor also comprises at least a portion of the measurement circuit.

22. The electronic utility meter of claim 20 wherein the processor includes a connection to a power supply output of a power supply, said power supply obtaining electrical power from said sensor module when the measurement module is coupled to the sensor module, and wherein said processor detects an interruption of the electrical power based on said connection.

23. The electronic utility meter of claim 20 wherein the processor is operable to set a flag upon determining that the measurement module is de-coupled from the sensor input upon detection of an interruption of electrical power to the housing input.

24. The electronic utility meter of claim 20 wherein the tamper protection circuit further comprises an installation continuity circuit, the installation continuity circuit including:
a first housing terminal coupled to a source of bias voltage, said first housing terminal adapted to be in electrical contact with a first portion of an electrically conductive element;
a second housing terminal coupled to the processor, said second housing terminal adapted to be in electrical contact with a second portion of the electrically conductive element; and
wherein said processor is operable to determine that said measurement module is de-coupled from the sensor module based on whether the bias voltage is present on the second housing terminal.

25. The electronic utility circuit of claim 20 wherein the tamper detection circuit further comprises an installation continuity circuit, the installation continuity circuit including:
a first housing terminal coupled to a source of bias voltage;
a second housing terminal coupled to the processor;
wherein the first housing terminal is electrically coupled to the second housing terminal when the measurement module is coupled to the sensor module, and wherein the first housing terminal is electrically de-coupled from the second housing terminal when the measurement module is de-coupled from the sensor module; and
wherein said processor is operable to determine that said measurement module is de-coupled from the sensor module based on whether the bias voltage is present on the second housing terminal.

26. The electronic utility meter of claim 25 wherein:
the first housing terminal is adapted to be in electrical contact with a first portion of an electrically conductive element only when the housing is in the installed position; and the second housing terminal is adapted to be in electrical contact with a second portion of the electrically conductive element only when the housing is in the installed position.
